# EUROPEAN PATENT SPECIFICATION

(11) **EP 2 717 297 B1**
(45) Date of publication and mention of the grant of the patent: **27.07.2016**
(21) Application number: 12788773.5
(22) Date of filing: 23.05.2012
(51) Int. Cl.: H01L 21/304, B24B 37/00, C09K 3/14, C09G 1/00

(54) **EROSION INHIBITOR FOR CHEMICAL MECHANICAL POLISHING, SLURRY FOR CHEMICAL MECHANICAL POLISHING, AND CHEMICAL MECHANICAL POLISHING METHOD**
EROSIONSHEMMER FÜR CHEMISCH-MECHANISCHES POLIEREN, AUFSCHLÄMMUNG ZUM CHEMISCH-MECHANISCHEN POLIEREN UND CHEMISCH-MECHANISCHES POLIERVERFAHREN
INHIBITEUR D'ÉROSION POUR UN POLISSAGE CHIMICO-MÉCANIQUE, BOUILLIE POUR UN POLISSAGE CHIMICO-MÉCANIQUE ET PROCÉDÉ DE POLISSAGE CHIMICO-MÉCANIQUE

(30) Priority: 24.05.2011 JP 2011116356
(43) Date of publication of application: 09.04.2014
(73) Proprietor: KURARAY CO., LTD., Kurashiki-shi Okayama 710-0801 (JP)
(72) Inventor: KATO, Mitsuru, Kurashiki-shi Okayama 713-8550 (JP); TAKEGOSHI, Minori, Kurashiki-shi Okayama 713-8550 (JP); OKAMOTO, Chihiro, Kurashiki-shi Okayama 713-8550 (JP); KATO, Shinya, Kurashiki-shi Okayama 713-8550 (JP)
(74) Representative: dompatent von Kreisler Selting Werner - Partnerschaft von Patent- und Rechtsanwälten mbB
(86) International application number: PCT/JP2012/063114
(87) International publication number: WO 2012/161202

(56) References cited:
- WO-A1-2011/058952
- WO-A2-2008/080958
- JP-A- 2007 242 839
- JP-A- 2009 206 240
- US-A- 3 642 671
- US-A- 4 230 824
- US-A- 5 770 103
- US-B1- 6 616 514

## Description

### Technical Field

The present invention relates to an erosion inhibitor for chemical mechanical polishing, a slurry for chemical mechanical polishing and a chemical mechanical polishing method, which are preferable for the production of semiconductor devices. Here, the "erosion inhibitor for chemical mechanical polishing" means an additive that is added to a slurry for chemical mechanical polishing to prevent a phenomenon called "erosion" wherein both a stopper film and an insulating film are removed.

The erosion inhibitor for chemical mechanical polishing and the slurry for chemical mechanical polishing of the present invention are preferably used for an isolation step of a semiconductor element, planarization of an interlayer dielectric film, formation of plug and embedded metal wiring, more preferably an isolation step of a semiconductor element.

### Background Art

A semiconductor circuit has been made to show a high performance by high densification achieved by miniaturization of transistor, resistance, wiring and the like constituting a circuit, and simultaneously by high-speed responses. In addition, lamination of wirings has enabled higher densification and higher integration. The semiconductor production techniques that have enabled the above include. STI (Shallow Trench Isolation), planarization of an interlayer dielectric film, damascene process, and metal plug. STI means transistor element isolation, the damascene means an embedding technique of metal wiring and the metal plug means three-dimensional wiring using a metal having a structure penetrating an interlayer dielectric film. The technique essential for each step is CMP (Chemical Mechanical Polishing), which is constantly used for each step of STI formation, planarization of an interlayer dielectric film, damascene process and metal plug embedding. These fine patterns are formed by transcription of a resist mask formed by a photolithography step. As miniaturization proceeds, the depth of the focus of the projector lens used for the lithography becomes shallow, and the required level of flatness becomes high, since the concaves and convexes on the wafer needs to be smaller than the depth. By planarizing the worked surface by CMP, a flat surface of a nano order atom level can be obtained, and high performance by three-dimensional wiring, i.e., lamination, becomes possible.

In an STI formation step, after formation of a groove to be an element isolation region and formation of a polishing stopper film on regions other than the groove, an insulating film for element isolation is formed inside the groove and on the polishing stopper film. Then, an excess insulating film is removed by polishing with CMP until the polishing stopper film appears, and planarized. As the stopper film, silicon nitride is generally used and, as the insulating film, silicon oxide is often used.

For high planarization and element protection, it is necessary to decrease the rate of polishing the stopper film and insulating film, when the stopper film is exposed. To certainly expose the stopper film on the entire surface of a wafer, a region on the wafer where the polishing rate is fast is polished for a comparatively long time even after exposure of the stopper film. When the polishing rate of the stopper film is high, a phenomenon called "erosion" occurs wherein both the stopper film and the insulating film are removed, and the insulating film for element isolation becomes thin. On the other hand, when the polishing rate of an insulating film is high even after exposure of the stopper film, a phenomenon called "dishing" is developed wherein the insulating film on the concave part of the pattern is excessively removed, and again, the insulating film for element isolation becomes thin.

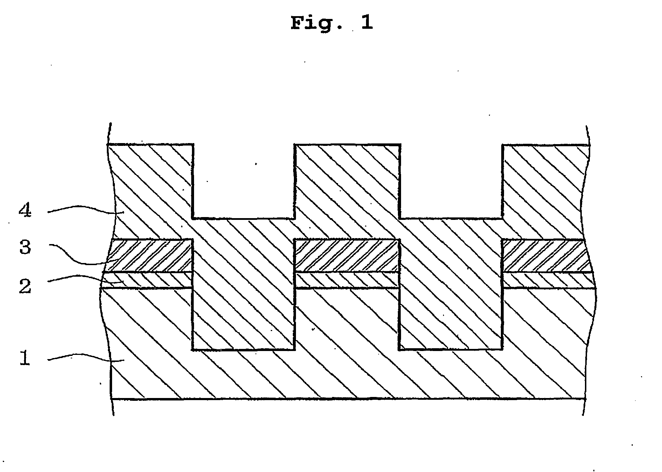

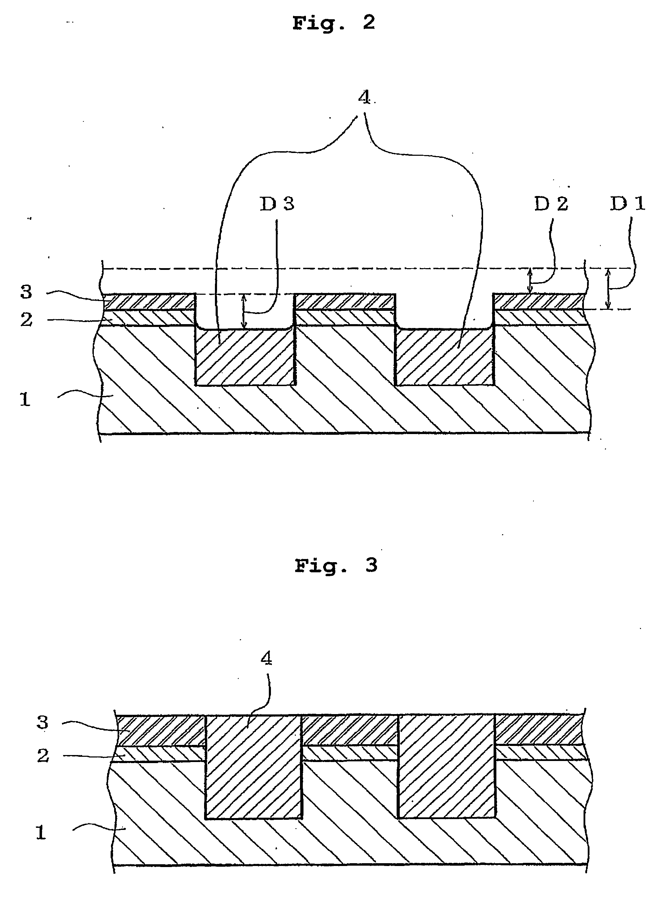

The erosion and dishing are further explained by referring to Figs. 1 - 3. Fig. 1 is a schematic sectional view of a patterned wafer before polishing, wherein an oxidized insulating film 2 (silicon oxide and the like), a stopper film 3 (silicon nitride and the like) and an insulating film 4 (silicon oxide and the like) are formed on a silicon wafer 1. Fig. 2 is a schematic sectional view of a patterned wafer after polishing which shows occurrence of erosion and dishing. The patterned wafer of Fig. 2 shows an erosion wherein both a stopper film 3 and an insulating film 4 have been removed, and a dishing wherein an insulating film on the concave part of the pattern has been excessively removed (D1: initial film thickness of stopper film, D2: erosion amount, D3: dishing amount). Fig. 3 is a schematic sectional view of a patterned wafer after polishing wherein erosion and dishing are suppressed. The size of each part in the drawings was set to facilitate understanding and the size ratio between each part and each part does not necessarily match the actual ratio.

Currently, a slurry containing ceria (cerium oxide) abrasive grains and an anionic polymer in combination is mainly used for STI formation (e.g., patent documents 1 and 2). A slurry containing ceria abrasive grains has a superior planarization ability, but requires a high cost and shows poor dispersion stability of the abrasive grains, due to which the slurry problematically changes easily with time, and easily develops a polishing flaw on the polished film.

To solve the above-mentioned problem of a slurry containing ceria abrasive grains, a slurry containing silica abrasive grains and various water-soluble compounds in combination has been proposed (e.g., patent documents 3 - 9). However, all of the patent documents 3 - 9 use unpatterned blanket wafers to separately measure a polishing rate for a silicon oxide film and a silicon nitride film. According to the verification of the present inventors, it was found that, even when a slurry showing a high ratio of polishing rate (ratio of the polishing rate of a silicon oxide film to that of a silicon nitride film) on unpatterned blanket wafers is used, the slurry shows an insufficient polishing inhibitory effect on the silicon nitride film when the wafer has a concave convex pattern composed of a silicon nitride film and a silicon oxide film, which is similar to the pattern used for actual semiconductor devices. The causes thereof are considered to be a substantially high pressure applied on a silicon nitride film of the convex part in a patterned wafer as compared to blanket wafers, and a phenomenon of desorption of a water-soluble compound adsorbed to a silicon nitride film of the convex part and entry thereof into the concave part.

In addition, a slurry containing silica abrasive grains and polyethyleneimine in combination has been studied (for example, patent documents 10 - 12). Table 2 of patent document 10 teaches that, when polyethyleneimine ("PEI" described in patent document 10) is added to a slurry containing silica abrasive grains, the ratio of the polishing rate of a silicon oxide film ("PE-TEOS" described in patent document 10) to that of a silicon nitride film ("Si₃N" described in patent document 10) decreases as the polyethyleneimine amount increases. From this it is considered that a slurry containing a simple combination of silica abrasive grains and polyethyleneimine is not suitable as a slurry for chemical mechanical polishing for STI formation. Moreover, patent documents 11 and 12 aim to prevent a roughened wafer surface (haze) after polishing, and do not aim to decrease a polishing amount in excessive polishing or a residual difference in the level in an STI formation step.

### [Document List]

### [patent documents]

patent document 1: JP-B-3672493
patent document 2: JP-B-3649279
patent document 3: JP-A-2000-144111
patent document 4: JP-A-2002-114967
patent document 5: JP-A-2002-118082
patent document 6: JP-A-2002-201462
patent document 7: JP-A-2002-261053
patent document 8: JP-A-2005-159351
patent document 9: JP-A-2008-187191
patent document 10: JP-A-2002-305167
patent document 11: JP-A-2006-352042
patent document 12: JP-A-2007-19093

### SUMMARY OF THE INVENTION

### Problems to be Solved by the Invention

The present invention aims to provide an erosion inhibitor for chemical mechanical polishing which can effectively prevent erosion and dishing.

### Means of Solving the Problems

The present inventors have conducted intensive studies and found that the above-mentioned object can be achieved by using a particular hydroxyl group-containing compound and a particular amino group-containing compound in combination, which resulted in the completion of the following present invention.

The subject-matter of the present invention is defined in claims 1-12 as attached.

### Effect of the Invention

Using a slurry for chemical mechanical polishing, which contains the erosion inhibitor for chemical mechanical polishing of the present invention, erosion and dishing can be effectively suppressed.

### Brief Description of the Drawings

Fig. 1 is a schematic sectional view of a patterned wafer before polishing.
Fig. 2 is a schematic sectional view of a patterned wafer after polishing, wherein erosion and dishing occur.
Fig. 3 is a schematic sectional view of a patterned wafer after polishing, wherein erosion and dishing are suppressed. Description of Embodiments

The present invention is explained in detail the following. The erosion inhibitor for chemical mechanical polishing of the present invention contains (a) a compound having a molecular weight of not more than 100,000 and not less than 4 hydroxyl groups (hereinafter sometimes to be abbreviated as "compound (a)"), and (b) a compound having not less than 4 amino groups (hereinafter sometimes to be abbreviated as "compound (b)") as essential components. The erosion inhibitor for chemical mechanical polishing of the present invention may be composed only of compound (a) and compound (b), or may contain an optional component (e.g., water and the like) other than these. When the erosion inhibitor for chemical mechanical polishing contains an optional component other than water, the content of the optional component other than water is preferably not more than 70 mass %, more preferably not more than 50 mass %, further preferably not more than 30 mass %, relative to the total amount of compound (a) and compound (b).

The mass ratio of compound (a) and compound (b) (i.e., compound (a)/compound (b)) in the erosion inhibitor for chemical mechanical polishing needs to be 0.10 - 500. When the mass ratio is less than 0.10, or exceeds 500, a polishing inhibitory effect on the stopper film becomes low when a patterned wafer is polished, and an erosion wherein a stopper film and an insulating film adjacent to the stopper film are excessively polished occurs. The mass ratio thereof is preferably 0.10 - 300, more preferably 0.10 - 100, further preferably 0.50 - 100, particularly preferably 0.50 - 70, most preferably 1.0 - 50.

When only one of compound (a) and compound (b) is used, a polishing inhibitory effect on the stopper film becomes low when a patterned wafer is polished, and an erosion wherein a stopper film and an insulating film adjacent to the stopper film are excessively polished occurs. In addition, when a compound having less than 4 hydroxyl groups is used instead of compound (a), and when a compound having less than 4 amino groups is used instead of compound (b), a polishing inhibitory effect on the stopper film becomes low when a patterned wafer is polished, and an erosion wherein a stopper film and an insulating film adjacent to the stopper film are excessively polished occurs.

The number of the hydroxyl group in compound (a) is preferably not less than 5, more preferably not less than 6, further preferably not less than 7. On the other hand, while the upper limit of the number of the hydroxyl group in compound (a) is not particularly limited, from the aspects of availability of compound (a) and the like, the number of he hydroxyl group in compound (a) is preferably not more than 4000, more preferably not more than 1000, further preferably not more than 300.

The number of the amino group in compound (b) is preferably not less than 5, more preferably not less than 6, further preferably not less than 7. On the other hand, while the upper limit of the number of the amino group in compound (b) is not particularly limited, from the aspects of availability of compound (b) and the like, the number of the amino group in compound (b) is preferably not more than 3000, more preferably not more than 700, further preferably not more than 200.

The hydroxyl group content of compound (a) is 5 - 40 mmol/g. When the hydroxyl group content is within the above-mentioned range, compound (a) concurrently shows good water-solubility and good adsorbability to a film to be polished, and polishing of a stopper film and an insulating film on a concave part of a pattern is further suppressed. The hydroxyl group content of compound (a) is preferably 10 - 35 mmol/g, further preferably 15 - 30 mmol/g. The hydroxyl group content of compound (a) can be measured by a method according to JIS K 0070. When compound (a) is a single compound and its chemical structure is known, the hydroxyl group content of compound (a) can be calculated from the molecular weight and the number of the hydroxyl groups therein.

In the present invention, compound (a) needs to have a molecular weight of not more than 100,000. When the molecular weight of compound (a) exceeds 100,000, the viscosity of the slurry for polishing becomes high, the polishing rate and the polishing uniformity decrease, and erosion and dishing cannot be effectively prevented. The molecular weight of compound (a) is 100 - 50,000, preferably 150 - 50,000, further preferably 200 - 10,000. When the molecular weight of compound (a) is less than 100, the adsorbability of compound (a) to a film to be polished becomes weak, and a polishing inhibitory effect on a stopper film and an insulating film on a concave part of a pattern tends to be low. When compound (a) is a polymer and substantially a mixture of compounds with various molecular weights, "the molecular weight of compound (a)" is a "weight average molecular weight of compound (a)". The weight average molecular weight of compound (a) is measured by size exclusion chromatography (SEC) wherein polyethylene oxide is used as a standard sample for calibration.

Examples of compound (a) include monosaccharides such as arabinose, xylose, fructose, sorbose, tagatose, glucose, mannose, galactose, fucose, rhamnose and the like; disaccharides such as sucrose, lactose, maltose, isomaltose, trehalose, gentiobiose, xylobiose, isomaltulose and the like; trisaccharides such as raffinose, maltotriose, isomaltotriose, kestose, gentiotriose, xylotriose and the like; tetrasaccharide such as nystose, isomaltotetraose, gentiotetraose, xylotetraose and the like; pentasaccharides such as fructofuranosylnystose and the like; cyclodextrins such as α-cyclodextrin, β-cyclodextrin, γ-cyclodextrin, δ-cyclodextrin, methyl-β-cyclodextrin, hydroxyethyl-β-cyclodextrin, hydroxypropyl-β-cyclodextrin and the like; cyclodextran wherein 5 - 20 glucoses are linked in a cycle; polysaccharides such as dextrin, dextran, inulin, hydroxyethylcellulose, hydroxypropylcellulose and the like; sugar alcohols such as erythritol, xylitol, sorbitol, mannitol, inositol, lactitol, maltitol, isomultitol and the like; hydroxyl group-containing synthetic polymers such as polyvinyl alcohol, poly(2-hydroxyethyl (meth)acrylate), poly(2-hydroxypropyl (meth)acrylate) and the like; and a derivative thereof, and one or more kinds of these can be used.' In the present invention, the "(meth)acrylic acid" refers to "methacrylic acid and acrylic acid".

Of compounds (a), compound (a) having a skeleton derived from a monosaccharide is preferable, since it shows a particularly high polishing inhibitory effect on a stopper film when a patterned wafer is polished and shows an extremely high synergistic effect by a combined use with compound (b). Compound (a) is more preferably at least one selected from the group consisting of compounds wherein 2 - 50 monosaccharides are bonded (e.g., disaccharides, trisaccharides, tetrasaccharides, pentasaccharides, cyclodextrins, cyclodextran, low molecular weight dextran etc.) and a derivative thereof (e.g., sugar alcohols obtained by reduction by hydrogenation of a part of the skeleton of a compound wherein 2 - 50 monosaccharides are bonded etc.). Compound (a) is further preferably at least one selected from the group consisting of disaccharides, trisaccharides, sugar alcohols obtained by reduction of disaccharides and cyclodextrins, and particularly preferably, sucrose, raffinose, kestose, lactitol or α-cyclodextrin.

The amino group content of compound (b) is 3 - 30 mmol/g. Compound (b) having an amino group content within the above-mentioned range concurrently shows good water-solubility and good adsorbability to a film to be polished, and polishing of a stopper film and an insulating film on a concave part of a pattern is further suppressed. The amino group content of compound (b) is preferably 5 - 25 mmol/g, further preferably 7 - 20 mmol/g. The amino group content of compound (b) can be measured by a method according to JIS K7237. When compound (b) is a single compound and its chemical structure is known, the amino group content of compound (b) can be calculated from the molecular weight and the number of the amino groups therein.

The molecular weight of compound (b) is 300 - 100,000, preferably 400 - 30,000, further preferably 500 - 10,000. When the molecular weight of compound (b) is less than 300, the adsorbability of compound (b) to a film to be polished becomes weak, and a polishing inhibitory effect on a stopper film and an insulating film on a concave part of a pattern tends to be low. When the molecular weight of compound (b) exceeds 100,000, the viscosity of the slurry for polishing becomes high, the polishing rate and the polishing uniformity decrease, and abrasive grains sometimes tend to coagulate. When compound (b) is a polymer and substantially a mixture of compounds with various molecular weights, "the molecular weight of compound (b)" is a "number average molecular weight of compound (b)". The number average molecular weight of compound (b) is measured by an ebullioscopic method.

Examples of compound (b) include polyalkyleneimine (b1) (e.g., polyethyleneimine, polypropyleneimine, polybutyleneimine, N-methylpolyethyleneimine etc.); polymer (b2) obtained by polymerizing 25 - 100 mass % of at least one monomer selected from the group consisting of allylamine, N-alkylallylamine (e.g., N-methylallylamine, N-ethylallylamine, N-propylallylamine etc.), N,N-dialkylallylamine (e.g., N,N-dimethylallylamine, N,N-diethylallylamine, N-methyl-N-ethylallylamine etc.), N-alkyldiallylamine (e.g., N-methyldiallylamine, N-ethyldiallylamine etc.), vinylamine, vinylpyridine and N,N-dialkylaminoethyl (meth)acrylate (for example, (meth)acrylic acid-N,N-dimethylaminoethyl, (meth)acrylic acid-N,N-diethylaminoethyl etc.), and 75 - 0 mass % of other monomer having an unsaturated double bond (e.g., methyl (meth)acrylate, ethyl (meth)acrylate, (meth)acrylamide, N,N-dimethyl(meth)acrylamide, styrene, methyl vinyl ether, vinylpyrrolidone, ethylene, propylene, butadiene etc.); polylysine, polyornithine, water-soluble chitosan; and derivatives thereof, and one or more kinds of these can be used. In the present invention, "(meth)acrylamide" refers to "methacrylamide and acrylamide".

Compound (b) is preferably at least one selected from the group consisting of polyalkyleneimine (b1); polymer (b2) obtained by polymerizing 50 - 100 mass % of at least one monomer selected from the group consisting of allylamine, N-alkylallylamine, N,N-dialkylallylamine, diallylamine, N-alkyldiallylamine and N,N-dialkylaminoethyl (meth)acrylate, wherein the above-mentioned alkylene is an alkylene group having 1 - 6 carbon atoms, the above-mentioned alkyl is an alkyl group having 1 - 4 carbon atoms, and 50 - 0 mass % of other monomer having an unsaturated double bond; and derivatives thereof. Such a compound (b) shows a particularly high polishing inhibitory effect on a stopper film when a patterned wafer is polished and shows an extremely high synergistic effect by a combined use with compound (a).

Compound (b) is more preferably at least one selected from the group consisting of polyethyleneimine, polypropyleneimine, N-methylpolyethyleneimine, polyallylamine, poly(N-methylallylamine), poly(N,N-dimethylallylamine), poly(diallylamine), poly(N-methyldiallylamine), (allylamine/N,N-dimethylallylamine) copolymer, (allylamine/N-methyldiallylamine) copolymer, (N,N-dimethylallylamine/N-methyldiallylamine) copolymer and poly N,N-dialkylaminoethyl (meth)acrylate. Compound (b) is further preferably at least one selected from the group consisting of polyethyleneimine, N-methylpolyethyleneimine, polyallylamine, poly(N-methylallylamine), poly(N,N-dimethylallylamine), poly(diallylamine), poly(N-methyldiallylamine), (allylamine/N,N-dimethylallylamine) copolymer, (allylamine/N-methyldiallylamine) copolymer and (N,N-dimethylallylamine/N-methyldiallylamine) copolymer.

Using compound (b) having at least one secondary amino group and/or at least one tertiary amino group, the stability of slurry when mixed with abrasive grains tends to increase. Therefore, compound (b) is particularly preferably at least one selected from the group consisting of polyethyleneimine, N-methylpolyethyleneimine, poly(N-methylallylamine), poly(N,N-dimethylallylamine), poly(diallylamine), poly(N-methyldiallylamine), (allylamine/N,N-dimethylallylamine) copolymer, (allylamine/N-methyldiallylamine) copolymer and (N,N-dimethylallylamine/N-methyldiallylamine) copolymer.

The slurry for chemical mechanical polishing of the present invention contains the above-mentioned erosion inhibitor for chemical mechanical polishing (i.e., compound (a), compound (b)), abrasive grain (c), and water as essential components.

Abrasive grains generally used for chemical mechanical polishing can be used as abrasive grain (c) in the slurry for chemical mechanical polishing of the present invention. Examples of abrasive grain (c) include silica, alumina, zirconia, titania, ceria, germanium oxide, manganese oxide, zinc oxide, magnesium oxide, diamond, silicon carbide and the like. Of these, silica is preferable since it is superior in polishing rate and dispersion stability of abrasive grains and particularly exhibits the erosion protective effect of the present invention.

Abrasive grain (c) having an average particle size of 5 - 500 nm is preferable since it is superior in polishing rate and causes less polishing flaws on a polished film. The average particle size of abrasive grain (c) is more preferably 10 - 400 nm, further preferably 20 - 300 nm. The average particle size can be measured by a particle size analyzer "ELSZ-2" manufactured by Otsuka Electronics CO., LTD. and analyzed by a cumulant method.

The concentration of abrasive grain (c) in the slurry for chemical mechanical polishing of the present invention is preferably 0.2 - 30 mass %, more preferably 1 - 25 mass %, further preferably 3 - 20 mass %, since both the polishing rate and dispersion stability of abrasive grains become superior.

The concentration of compound (a) in the slurry for chemical mechanical polishing of the present invention is preferably 0.01 - 10 mass %, more preferably 0.05 - 8 mass %, further preferably 0.1 - 6 mass %, since both the polishing rate and erosion inhibitory effect become superior.

The concentration of compound (b) in the slurry for chemical mechanical polishing of the present invention is preferably 0.001 - 5 mass %, more preferably 0.01 - 1 mass %, further preferably 0.03 - 0.5 mass %, since both the polishing rate and erosion inhibitory effect become superior.

The pH of the slurry for chemical mechanical polishing of the present invention is preferably 9 - 13, more preferably 10 - 12, since all of the polishing rate, erosion inhibitory effect and dispersion stability of abrasive grains become superior. The pH can be adjusted by the addition of a base such as potassium hydroxide, sodium hydroxide, tetramethylammonium hydroxide, 2-hydroxyethyltrimethylammonium hydroxide, ammonia, trimethylamine, triethylamine, N,N-dimethylethanolamine, N,N-dibutylethanolamine, N-methyldiethanolamine, N-butyldiethanolamine, triethanolamine, imidazole or the like; an acid such as hydrochloric acid, nitric acid, sulfuric acid, acetic acid, citric acid, malic acid, phthalic acid or the like; an amino acid such as glycine, alanine, glutamic acid, aspartic acid or the like, a chelating agent such as ethylenediaminetetraacetic acid, dihydroxyethylglycine or the like; or the like to the slurry.

The slurry for chemical mechanical polishing of the present invention may further contain an optional component other than compound (a), compound (b), abrasive grain (c) and water. Examples of the optional component include compound (d) having two or three amino groups (hereinafter sometimes to be abbreviated as "compound (d)") and the like. A slurry containing compound (d) for chemical mechanical polishing tends to show a somewhat decreased erosion protective effect, though the polishing uniformity may be improved. A compound having only one amino group shows a smaller effect of improving the polishing uniformity. Compound (d) preferably has a molecular weight of less than 300.

Examples of compound (d) include ethylenediamine (molecular weight 60), diethylenetriamine (molecular weight 103), bis(hexamethylene)triamine (molecular weight 215), N,N,N',N",N"-pentamethyldiethylenetriamine (molecular weight 173), tetramethylenediamine (molecular weight 88), hexamethylenediamine (molecular weight 116), cyclohexanediamine (molecular weight 114), N,N'-diethylethylenediamine (molecular weight 116), N,N,N'-trimethylethylenediamine (molecular weight 102), N,N,N'-triethylethylenediamine (molecular weight 144), N,N,N',N'-tetramethylethylenediamine (molecular weight 116), N,N,N',N'-tetramethyl-1,3-propanediamine (molecular weight 130), N,N,N',N'-tetramethyl-1,6-hexanediamine (molecular weight 172), N,N'-dimethylpiperazine (molecular weight 114), 1-(2-hydroxyethyl)piperazine (molecular weight 130), 2-(2-aminoethylamino)ethanol (molecular weight 104), N-(3-aminopropyl)diethanolamine (molecular weight 162), N,N,N',N'-tetrakis(2-hydroxyethyl)ethylenediamine (molecular weight 236), lysin (molecular weight 146), ornithine (molecular weight 132) and the like. One or more kinds of these can be used. Of these, one having a molecular weight of 100 - 250 is particularly preferable as compound (d).

The concentration of compound (d) in the slurry for chemical mechanical polishing of the present invention is preferably less than 1 mass %, more preferably less than 0.5 mass %, further preferably less than 0.3 mass %, since all of the polishing rate, polishing uniformity, and erosion protective effect become superior..

The slurry for chemical mechanical polishing of the present invention may contain a water-soluble polymer such as polyethylene glycol, polyvinylpyrrolidone, poly(meth)acrylamide, poly(meth)acrylic acid or the like, and a surfactant, an antibacterial agent, a water-soluble organic solvent and the like, as long as the effect of the present invention is not inhibited.

The slurry for chemical mechanical polishing of the present invention is particularly useful for planarizing concave convex patterns formed on an insulating film, and especially suitable for use of planarizing an insulating film for element isolation by polishing in an STI formation step. The slurry for chemical mechanical polishing of the present invention can suppress the development of an erosion wherein both a stopper film and an insulating film have been removed, and a dishing wherein an insulating film of a concave part of a pattern has been excessively removed, since the polishing rate of both the stopper film and insulating film decreases upon exposure of the stopper film. As the stopper film, a silicon nitride film and a polysilicon film can be used, with particularly preference-given to a silicon nitride film, since the erosion inhibitory effect of the present invention is exhibited furthermore. The insulating film is preferably a silicon oxide film, since the dishing inhibitory effect of the present invention is particularly exhibited. The silicon oxide film may be modified with a small amount of boron, phosphorus, carbon, fluorine and the like.

As a method of chemical mechanical polishing using the slurry for chemical mechanical polishing of the present invention, a known method can be employed. Examples thereof include a method including pressing a wafer having a film to be polished formed thereon against a surface of a polishing pad adhered onto a polishing surface plate, while supplying the slurry of the present invention on, and rotating both the polishing surface plate and the wafer to polish the film to be polished. A polishing pad usable for the present invention is not particularly limited, and any of a foamed resin, an unfoamed resin, a non-woven fabric and the like can be used. It may be a single layer pad composed only of a polishing layer or may be a pad with a two-layer structure having a cushion layer provided under a polishing layer. As a method for supplying the slurry for chemical mechanical polishing of the present invention onto a polishing pad, one liquid containing all components may be fed or plural liquids containing each component may be fed and mixed on the way in a pipe or on a pad to a desired concentration. Moreover, the kind and concentration of each component may be change as appropriate during the polishing.

### Examples

The present invention is explained in more detail in the following by referring to Examples, which are not to be construed as limitative. The polishing performance was evaluated by the following methods.

### [pH of slurry for chemical mechanical polishing]

Using a pH meter "F-22" manufactured by Horiba, Ltd. and a standard buffer (phthalate pH buffer: pH 4.00 (25°C), neutral phosphate pH buffer: pH 7.00 (25°C), borate pH buffer: pH 9.00 (25°C)), three-point calibration was performed and the pH of a slurry for chemical mechanical polishing was measured at a controlled temperature of 25°C.

### [Measurement of thickness of silicon oxide film and silicon nitride film]

Using a thickness measuring apparatus "Nanospec Model 5100" manufactured by Nanometric, the thickness of silicon oxide film and silicon nitride film was measured with an objective lens at 10-fold magnification.

### [Measurement of level difference of patterned wafer]

Using a surface-roughness measuring apparatus "SJ-400" manufactured by Mitutoyo Corporation, the measurement was performed under the setting of standard stylus, measurement range 80 µm, JIS 2001, GAUSS filter, cutoff value λc 2.5 mm, and cutoff value λs 8.0 µm, and the level difference of a patterned wafer was determined from a section curve.

### [Evaluation of patterned wafer polishing performance]

A polishing pad "IC1400 (concentric circular groove); diameter 380 mm" manufactured by Nitta Haas Incorporated was adhered to a polishing surface plate of a polishing apparatus "BC-15" manufactured by MAT Ltd. Using a diamond dresser (diamond No. #100; diameter 190 mm) manufactured by A.L.M.T. Corp., the surface of the polishing pad was ground at dresser rotation 140 rpm, polishing pad rotation 100 rpm, dresser load 5N for 60 min while flowing pure water at a rate of 150 mL/min (hereinafter to be referred to as "conditioning").

Then, a silicon wafer (diameter 2 inch) having a 1000 nm-thick unpatterned silicon oxide film (PETEOS silicon oxide film formed by plasma chemical vapor deposition) on its surface was polished, without conditioning, for 60 sec under the conditions of polishing pad rotation 100 rpm, wafer rotation 99 rpm, and polishing pressure 24 kPa, while supplying a polishing slurry at a rate of 120 mL/min. Then, after conditioning for 30 sec, the wafer was exchanged, polishing and conditioning were repeated, and total ten wafers were polished. Also, one patterned wafer for STI polishing evaluation "SKW3-2" manufactured by SKW, which has a concave convex pattern formed by alternately and repeatedly arranged linear convex parts and concave parts, was polished under the same conditions as above. The initial level difference between the convex part and the concave part of the pattern was about 500 nm. The convex part of the pattern has a structure wherein a 13 nm-thick silicon oxide film is laminated on a silicon wafer, a 110 nm-thick silicon nitride film is laminated thereon, and a 670 nm-thick silicon oxide film (HDP silicon oxide film formed by high density plasma chemical vapor deposition) is laminated thereon, and the concave part of the pattern has a structure wherein a 670 nm-thick HDP silicon oxide film is formed on a groove formed by etching the silicon wafer by 400 nm. A pattern of convex part width 100 µm and concave part width 100 µm, which is located at about 50 mm from the center of the wafer, was used as a measurement target of film thickness and level difference. The time point when the silicon oxide film on the convex part of the silicon nitride film disappeared by polishing was taken as just polishing, and the thicknesses and pattern level difference of the silicon oxide film and silicon nitride film at just polishing were measured. Thereafter, the wafer was further polished only for the time corresponding to 15% of the polishing time required for just polishing to perform a model excessive polishing test, and the film thickness and level difference were measured again.

The polishing amount of the silicon nitride film during excessive polishing added after the just polishing was evaluated as "erosion amount", and the polishing amount of the silicon oxide film during excessive polishing was evaluated as "dishing amount". A smaller value is more preferable for both of them.

### [Evaluation of unpatterned wafer polishing performance]

A polishing pad "IC1400 (concentric circular groove); diameter 380 mm" manufactured by Nitta Haas Incorporated was adhered to a polishing surface plate of a polishing apparatus "BC-15" manufactured by MAT Ltd. Using a diamond dresser (diamond No. #100; diameter 190 mm), conditioning was performed at dresser rotation 140 rpm, polishing pad rotation 100 rpm, and dresser load 5N for 60 min while flowing pure water at a rate of 150 mL/min.

Then, a silicon wafer (diameter 4 inch) having a 1000 nm-thick unpatterned silicon oxide film (PETEOS silicon oxide film formed by plasma chemical vapor deposition) on its surface was polished, without conditioning, for 60 sec under the conditions of polishing pad rotation 100 rpm, wafer rotation 99 rpm, and polishing pressure 24 kPa, while supplying a polishing slurry at a rate of 120 mL/min. Then, after conditioning for 30 sec, the wafer was exchanged, polishing and conditioning were repeated, and total ten wafers were polished. Then, a wafer having a 1000 nm-thick unpatterned silicon oxide film (PETEOS silicon oxide film formed by plasma chemical vapor deposition) on its surface was polished under the same conditions as above for 60 sec, subjected to conditioning for 30 sec, and a wafer having a 100 nm-thick unpatterned silicon nitride film on its surface was polished under the same conditions as above for 60 sec.

The wafer having a silicon oxide film on its surface and polished eleventh and the wafer having a silicon nitride film on its surface and polished twelfth were each measured for the film thicknesses at 49 points in the wafer surface before and after polishing, the polishing rate at each point was determined, and an average of the polishing rates at 49 points was taken as the "polishing rate" of each wafer.

### [Example 1]

Polyethyleneimine having a number average molecular weight of 1800 ("EPOMIN SP-018" manufactured by NIPPON SHOKUBAI CO., LTD.) (2.0 g) and α-cyclodextrin having a molecular weight of 972 ("NISSHOKU CELLDEX-A" manufactured by NIHON SHOKUHIN KAKO CO., LTD.) (40 g) were dissolved in pure water (1358 g), and the solution was uniformly mixed with a silica slurry ("Semi-Sperse 25" manufactured by Cabot Microelectronics) (600 g) to give a slurry for chemical mechanical polishing. The concentration of polyethyleneimine in the slurry was 0.1 mass%, the concentration of α-cyclodextrin was 2.0 mass%, the concentration of the silica abrasive grains was 7.5 mass%. In addition, the pH of the slurry was 11.2.

The patterned wafer polishing performance was evaluated by the above-mentioned method. As a result, as shown in Table 2, the erosion amount was as small as 5 nm, and the dishing amount was as small as 14 nm, and the slurry was superior in a polishing inhibitory effect on the silicon nitride film and silicon oxide film in excessive polishing. In addition, when the unpatterned wafer polishing performance was evaluated according to the above-mentioned method, the ratio of the polishing rate of the silicon oxide film to that of the silicon nitride film was 1.9, as shown in Table 2.

### [Examples 2 - 7]

In the same manner as in Example 1 except that the component and concentration of the slurry for chemical mechanical polishing were changed as shown in Table 1, slurries for chemical mechanical polishing were prepared. The pH of each slurry was as shown in Table 1. As the allylamine/dimethylallylamine copolymer having a number average molecular weight of 700, "PAA-1112" manufactured by Nitto Boseki CO., LTD. after removing a low molecular weight component therefrom by preparative chromatography was used.

Using each slurry, the patterned wafer polishing performance was evaluated in the same manner as in Example 1. As a result, as shown in Table 2, both the erosion amount and dishing amount were small and the slurries was superior in the polishing inhibitory effect in excessive polishing. The ratio of the polishing rate of the silicon oxide film to that of the silicon nitride film is as shown in Table 2.

### [Examples 8 - 14]

In the same manner as in Example 1 except that the component and concentration of the slurry for chemical mechanical polishing were changed as shown in Table 3, slurries for chemical mechanical polishing were prepared. The pH of each slurry is as shown in Table 3. As the polyethyleneimine having a number average molecular weight of 600, "EPOMIN SP-006" manufactured by NIPPON SHOKUBAI CO., LTD. was used and, as the polyethyleneimine having a number average molecular weight of 10,000, "EPOMIN SP-200" manufactured by NIPPON SHOKUBAI CO., LTD. was used.

Using each slurry, the patterned wafer polishing performance was evaluated in the same manner as in Example 1. As a result, both the erosion amount and dishing amount were small and the slurries were superior in the polishing inhibitory effect in excessive polishing, as shown in Table 4.

### [Examples 15 - 20]

In the same manner as in Example 1 except that the component and concentration of the slurry for chemical mechanical polishing were changed as shown in Table 5, slurries for chemical mechanical polishing were prepared. The pH of each slurry is as shown in Table 5. As the polyallylamine having a number average molecular weight of 650, "PAA-01" manufactured by Nitto Boseki CO., LTD. was used and, as the polyallylamine having a number average molecular weight of 2100, "PAA-03" manufactured by Nitto Boseki CO., LTD. was used and, as the polydiallylamine having a number average molecular weight of 3200, "PAS-21" manufactured by Nitto Boseki CO., LTD. was used after removal of low molecular weight components therefrom by preparative chromatography. In addition, as the polyethyleneimine having a number average molecular weight of 1200, "EPOMIN SP-012" manufactured by NIPPON SHOKUBAI CO., LTD. was used.

Using each slurry, the patterned wafer polishing performance was evaluated in the same manner as in Example 1. As a result, both the erosion amount and dishing amount were small and the slurries were superior in the polishing inhibitory effect in excessive polishing, as shown in Table 6.

### [Example 21]

Polyethyleneimine having a number average molecular weight of 1800 (manufactured by NIPPON SHOKUBAI CO., LTD. "EPOMIN SP-018") (2.0 g) and sucrose (100 g) were dissolved in pure water (200 g), and the solution was uniformly mixed with a silica slurry (a mixture of "PLANERLITE4101" manufactured by Fujimi Incorporated and "GZANZOX1302" manufactured by Fujimi Incorporated in a mass ratio of 75:10) (1698 g) to give a slurry for chemical mechanical polishing. The concentration of polyethyleneimine in the slurry was 0.1 mass%, the concentration of sucrose was 5.0 mass%, the concentration of the silica abrasive grains was 17.5 mass%. In addition, the pH of the slurry was 11.2.

The patterned wafer polishing performance was evaluated by the above-mentioned method. As a result, as shown in Table 6, the erosion amount was as small as of 12 nm and the dishing amount was as small as 29 nm, and the slurry was superior in the polishing inhibitory effect on the silicon nitride film and silicon oxide film in excessive polishing.

### [Comparative Example 1]

Pure water (1400 g) and a silica slurry ("Semi-Sperse 25" manufactured by Cabot Microelectronics) (600 g) were uniformly mixed to give a slurry for chemical mechanical polishing. Compound (a) and compound (b) were not present in the slurry, the concentration of silica abrasive grains was 7.5 mass%, and the pH of the slurry was 10.9.

The patterned wafer polishing performance was evaluated in the same manner as in Example 1. As a result, as shown in Table 8, both the erosion amount was as high as 21 nm and the dishing amount was as high as 53 nm, and the slurry was inferior in the polishing inhibitory effect on the silicon nitride film and silicon oxide film in excessive polishing. In addition, the unpatterned wafer polishing performance was evaluated according to the above-mentioned method. As a result, as shown in Table 8, the ratio of the polishing rate of the silicon oxide film to that of the silicon nitride film was 4.6.

### [Comparative Examples 2 - 8]

In the same manner as in Example 1 except that the component and concentration of the slurry for chemical mechanical polishing were changed as shown in Table 7, slurries for chemical mechanical polishing were prepared. The pH of each slurry is as shown in Table 7.

Using each slurry, the patterned wafer polishing performance was evaluated in the same manner as in Example 1. As a result, as shown in Table 8, both the erosion amount and dishing amount were high and the slurries were inferior in the polishing inhibitory effect in excessive polishing. The ratio of the polishing rate of the silicon oxide film to that of the silicon nitride film is as shown in Table 8.

### [Comparative Examples 9 - 16]

In the same manner as in Example 1 except that the component and concentration of the slurry for chemical mechanical polishing were changed as shown in Table 9, slurries for chemical mechanical polishing were prepared. The pH of each slurry is as shown in Table 9.

Using each slurry, the patterned wafer polishing performance was evaluated in the same manner as in Example 1. As a result, as shown in Table 10, both the erosion amount and dishing amount were high and the slurries were inferior in the polishing inhibitory effect in excessive polishing.

**Table 1**

| | | Example | | | | | | |
|---|---|---|---|---|---|---|---|---|
| | | 1 | 2 | 3 | 4 | 5 | 6 | 7 |
| compound (a) | kind | α-cyclodextrin (Fw:972) | α-cyclodextrin (Fw:972) | sucrose (Fw:342) | α-cyclodextrin (Fw:972) | α-cyclodextrin (Fw:972) | α-cyclodextrin (Fw:972) | sucrose (Fw:342) |
| | hydroxyl group content | 19 mmol/g | 19 mmol/g | 23 mmol/g | 19 mmol/g | 19 mmol/g | 19 mmol/g | 23 mmol/g |
| | concentration | 2.0% | 0.4% | 2.0% | 2.0% | 1.0% | 1.0% | 7.0% |
| compound (b) | kind | polyethylene-imine (Mn:1800) | polyethyleneimine (Mn:1800) | polyethylene-imine (Mn:1800) | allylamine/ dimethyl-allylamine copolymer (Mn:700) | allylamine/ dimethyl-allylamine copolymer (Mn:700) | allylamine/ dimethyl-allylamine copolymer (Mn:700) | allylamine/ dimethyl-allylamine copolymer (Mn:700) |
| | amino group content | 19.mmol/g | 19 mmol/g | 19 mmol/g" | 14 mmol/g | 14 mmol/g | 14 mmol/g | 14 mmol/g |
| | concentration | 0.1% | 0.1% | 0.1% | 0.1% | 0.07% | 0.06% | 0.07% |
| abrasive grain (c) | kind | silica | silica | silica | silica | silica | silica | silica |
| | concentration | 7.5% | 7.5% | 7.5% | 7.5% | 7.5% | 5.0% | 7.5% |
| slurry pH | | 11.2 | 11.2 | 11.2 | 11.2 | 11.1 | 11.0 | 11.0 |
| compound (a)/ compound (b) | | 20 | 4 | 20 | 20 | 14 | 17 | 100 |

| | | | | | | | | |
|---|---|---|---|---|---|---|---|---|
| %= mass %, Fw = molecular weight, Mn = number average molecular weight, silica = Semi-Sperse 25 | | | | | | | | |

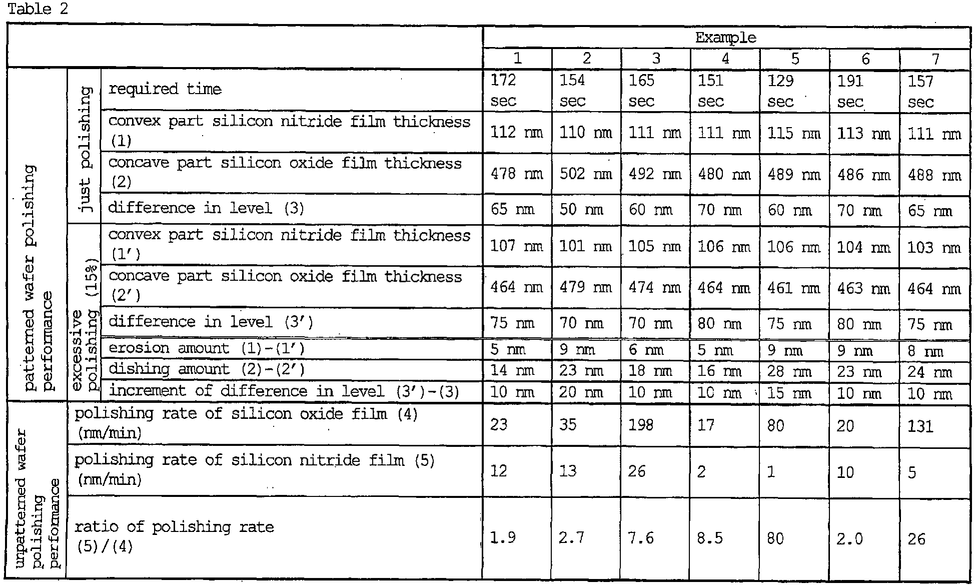

**Table 3**

| | | Example | | | | | | |
|---|---|---|---|---|---|---|---|---|
| | | 8 | 9 | 10 | 11 | 12 | 13 | 14 |
| compound (a) | kind | α-cyclodextrin (Fw:972) | α-cyclodextrin (Fw:972) | trehalose (Fw:342) | raffinose (Fw:504) | sorbitol (Fw:182) | xylitol (Fw:152) | lactitol (Fw:344) |
| | hydroxyl group content | 19 mmol/g | 19 mmol/g | 23 mmol/g | 21 mmol/g | 33 mmol/g | 33 mmol/g | 26 mmol/g |
| | concentration | 2.0% | 2.0% | 2.5% | 1.5% | 3.0% | 3.0% | 2.0% |
| compound (b) | kind | poly-ethylene-imine (Mn:600) | polyethylene-imine (Mn:10000) | poly-ethylene-imine (Mn:1800) | polyethylene-imine (Mn:1800) | polyethylene-imine (Mn:1800) | polyethylene-imine (Mn:1800) | polyethylene-imine (Mn:1800) |
| | amino group content | 20 mmol/g | 18 mmol/g | 19 mmol/g | 19 mmol/g | 19 mmol/g | 19 mmol/g | 19 mmol/g |
| | concentration | 0.1% | 0.1% | 0.1% | 0.1% | 0.1% | 0.1% | 0.1% |
| abrasive | kind | silica | silica | silica | silica | silica | silica | silica |
| grain (c) | concentration | 7.5% | 7.5% | 7.5% | 7.5% | 7.5% | 7.5% | 7.5% |
| slurry pH | | 11.3 | 11.0 | 11.2 | 11.1 | 11.1 | 11.1 | 11.1 |
| compound (a)/ compound (b) | | 20 | 20 | 25 | 15 | 30 | 30 | 20 |

| | | | | | | | | |
|---|---|---|---|---|---|---|---|---|
| %= mass %, Fw = molecular weight, Mn = number average molecular weight, silica = Semi-Sperse 25 | | | | | | | | |

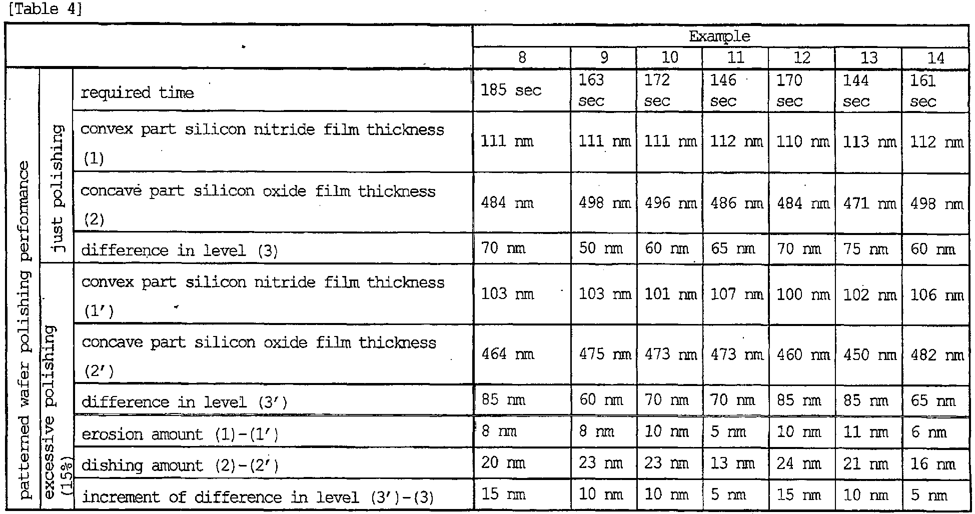

**[Table 5]**

| | | Example | | | | | | |
|---|---|---|---|---|---|---|---|---|
| | | 15 | 16 | 17 | 18 | 19 | 20 | 21 |
| compound (a) | kind | α-cyclodextrin (Ew:972) | α-cyclodextrin (Fw:972) | γ-cyclodextrin (Fw:1297) | sucrose (Fw:342) | α-cyclodextrin (Fw:972) | dextran (Mw:40000) | sucrose (Fw:342) |
| | hydroxyl group content | 19 mmol/g | 19 mmol/g | 19 mmol/g | 23 mmol/g | 19 mmol/g | 23 mmol/g | 23 mmol/g |
| | concentration | 2.0% | 0.4% | 0.6% | 3.0% | 2.0% | 1.5% | 5.0% |
| compound (b) | kind | polyallylamine (Mn:650) | polyallylamine (Mn:2100) | polyallylamine (Mn:2100) | polyallylamine (Mn:2100) | poly-diallylamine (Mn:3200) | polyethylene-imine (Mn:1200) | polyethylene-imine (Mn:1800) |
| | amino group content | 18 mmol/g | 18 mmol/g | 18 mmol/g | 18 mmol/g | 10 mmol/g | 19 mmol/g | 19 mmol/g |
| | concentration | 0.07% | 0.07% | 0.07% | 0.07% | 0.1% | 0.1% | 0.1% |
| abrasive grain (c) | kind | silica | silica | silica | silica | silica | silica | silica* |
| | concentration | 7.5% | 7.5% | 7.5% | 7.5% | 7.5% | 7.5% | 17.5% |
| slurry pH | | 11.1 | 11.1 | 11.1 | 11.1 | 11.0 | 11.1 | 11.2 |
| compound (a)/ compound (b) | | 29 | 6 | 9 | 43 | 20 | 15 | 50 |

| | | | | | | | | |
|---|---|---|---|---|---|---|---|---|
| % = mass %, Fw = molecular weight, Mn = number average molecular weight, Mw = weight average molecular weight silica = Semi-Sperse 25 (silica* in Example 21 = a mixture of GLANZOX1302 and PLANERLITE4101) | | | | | | | | |

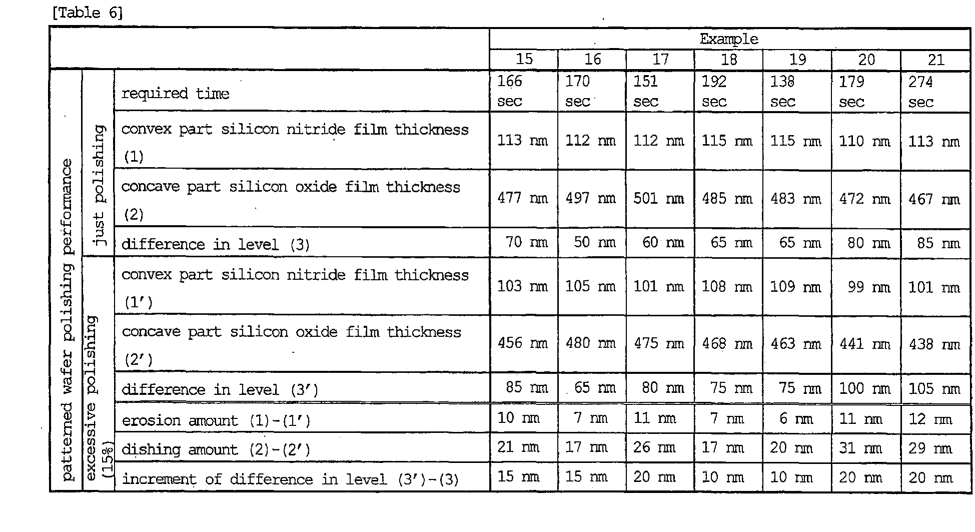

**[Table 7]**

| | | Comparative Example | | | | | | | |
|---|---|---|---|---|---|---|---|---|---|
| | | 1 | 2 | 3 | 4 | 5 | 6 | 7 | 8 |
| compound (a) | kind | - | α-cyclodextrin (Fw:972) | sucrose (Fw:342) | sorbitol (Fw:182) | - | - | α-cyclodextrin (Fw:972) | α-cyclodextrin (Fw:972) |
| | hydroxyl group content | - | 19 mmol/g | 23 mmol/g | 33 mmol/g | - | - | 19 mmol/g | 19 mmol/g |
| | concentration | - | 2.1% | 7.0% | 7.0% | - | - | 0.006% | 9.0% |
| compound (b) | kind | - | - | - | - | polyethylene- imine (Mn:1800) | polyethylene- imine (Mn:800) | polyethylene-imine (Mn:1800) | polyethylene-imine (Mn:1800) |
| | amino group content | - | - | - | - | 19 mmol/g | 19 mmol/g | 19 mmol/g | 19 mmol/g |
| | concentration | - | - | - | - | 0.03% | 0.1% | 0.15% | 0.01% |
| abrasive grain (c) | kind | silica | silica | silica | silica | silica | silica | silica | silica |
| | concentration | 7.5% | 7.5% | 7.5% | 7.5% | 7.5% | 7.5% | 7.5% | 7.5% |
| slurry pH | | 10.9 | 10.8 | 10.7 | 10.5 | 10.9 | 11.2 | 11.3 | 10.9 |
| compound (a)/ compound (b) | | - | - | - | - | - | - | 0.04 | 900 |

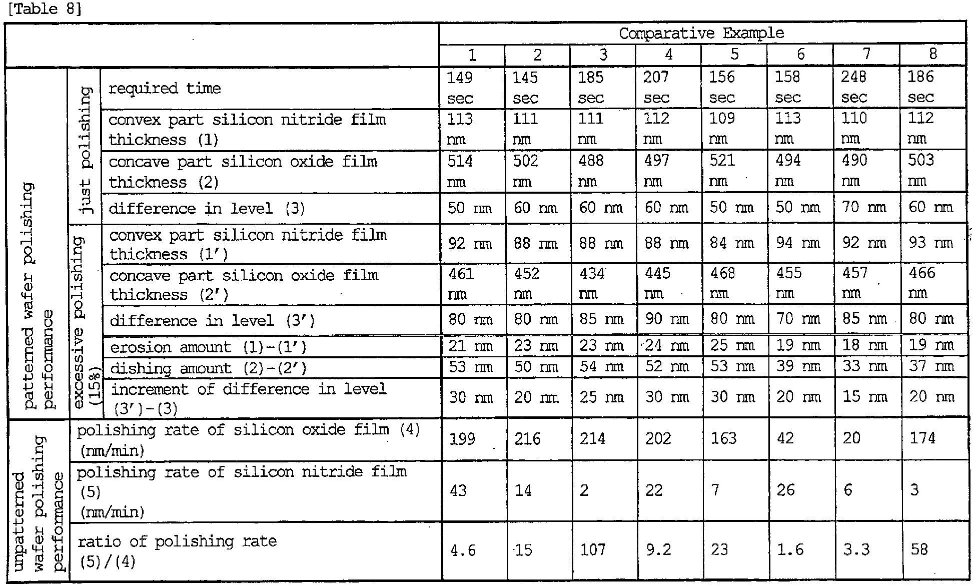

| [0078] | | | | | | | | | |
|---|---|---|---|---|---|---|---|---|---|
| [Table 9] | | | | | | | | | |
| | | Comparative Example | | | | | | | |
| | | 9 | 10 | 11 | 12 | 13 | 14 | 15 | 16 |
| | kind | - | - | sucrose (Fw:342) | - | - | - | - | α-cyclodextrin (Fw:972) |
| compound (a) | hydroxyl group content | - | - | 23 mmol/g | - | - | - | - | 19 mmol/g |
| | concentration | - | - | 2.0% | - | - | - | - | 2.0% |
| compound (b) | kind | allylamine/ dimethyl- allylamine copolymer (Mn:700) | poly- diallylamine (Mn:3200) | - | polyethylene- imine (Mn:1800) | poly- ethylene- imine (Mn:1800) | poly- ethylene- imine (Mn:1800) | - | - |
| | amino group content | 14 mmol/g | 10 mmol/g | - | 19 mmol/g | 19 mmol/g | 19 mmol/g | - | - |
| | concentration | 0.1% | 0.1% | - | 0.1% | 0.1% | 0.1% | - | - |
| other compound | kind | - | - | diethylene-triamine | hydroxypropylcellulose^{*1} (Mw:130000) | polyethyleneglycol (Mn:2000) | N,N,N',N'-tetra-methyl-1,6-hexanediamine | N,N,N',N'-tetramethyl-1,6-hexanediamine | poly-vinyl-pyrrolidone^{*2} (Mv:10000) |
| | concentration | - | - | 0.3% | 1.0% | 2.0% | 0.2% | 0.3% | 0.1% |
| abrasive | kind | silica | silica | silica | silica | silica | silica | silica | silica |
| grain (c) | concentration | 7.5% | 7.5% | 7.5% | 7.5% | 7.5% | 7.5% | 7.5% | 7.5% |
| slurry pH | | 11.1 | 11.0 | 11.5 | 11.0 | 11.2 | 11.6 | 11.5 | 10.9 |
| compound (a)/ compound (b) | | - | - | - | - | - | - | - | - |

| | | | | | | | | | |
|---|---|---|---|---|---|---|---|---|---|
| % = mass %, Fw = molecular weight, Mn = number average molecular weight, Mw = weight average molecular weight, Mv = viscosity average molecular weight, silica=Semi-Sperse 25 **^{*1}** The hydroxyl group content of hydroxypropylcellulose in Comparative Example 12 = 9 mmol/g, ^{*2} The K value of polyvinylpyrrolidone in Comparative Example 16 = 15 | | | | | | | | | |

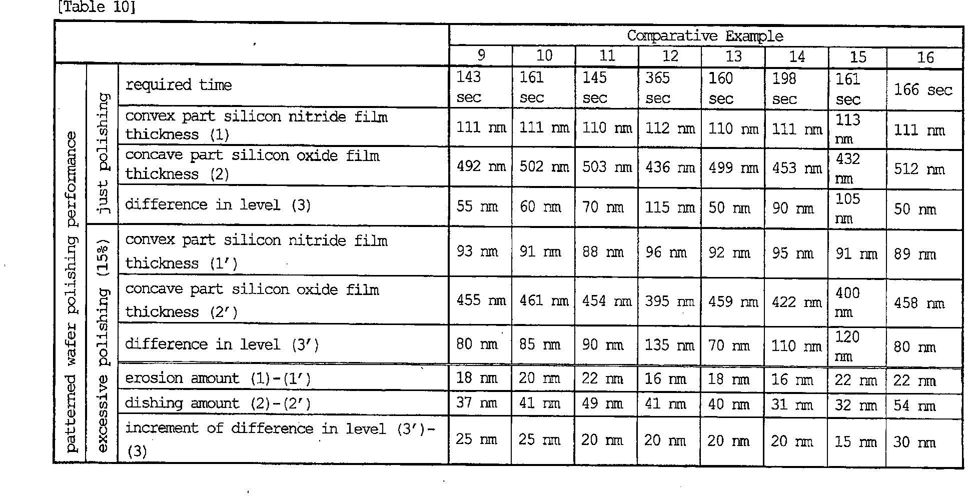

From the results of Examples 1 - 21, it is clear that the slurry for chemical mechanical polishing of the present invention, which contains both compound (a) and compound (b) at a suitable mass ratio, shows a small erosion amount and a small dishing amount when a patterned wafer is polished, and is superior in the polishing inhibitory effect in excessive polishing.

In contrast, from the results of Comparative Examples 1 - 16, it is clear that a slurry for chemical mechanical polishing, which contains only one of compound (a) and compound (b), or contains the both at an inappropriate mass ratio, shows a high erosion amount and a high dishing amount when polishing a patterned wafer, and is inferior in the polishing inhibitory effect in excessive polishing.

Furthermore, from the results of Comparative Examples 2 - 5, it is clear that, even when the ratio of the polishing rate of a silicon oxide film to that of a silicon nitride film is high, the patterned wafer polishing performance is sometimes insufficient. In addition, from the results of Examples 1, 2 and 6, it is clear that, even when the ratio of the polishing rate of a silicon oxide film to that of a silicon nitride film is low, the polishing performance of a patterned wafer is sometimes superior.

### [Industrial Applicability]

Using the slurry for chemical mechanical polishing, which contains the erosion inhibitor for chemical mechanical polishing of the present invention, erosion and dishing can be effectively suppressed. The erosion inhibitor for chemical mechanical polishing and slurry for chemical mechanical polishing of the present invention are particularly useful in an STI formation step for isolation of a semiconductor element.

### [Explanation of Symbols]

- 1: silicon wafer
- 2: oxidized insulating film (silicon oxide and the like)
- 3: stopper film (silicon nitride and the like)
- 4: insulating film (silicon oxide and the like)
- D1: initial film thickness of stopper film
- D2: erosion amount
- D3: dishing amount

## Claims

1. Use of an additive comprising compound (a) and compound (b) as an erosion inhibitor for chemical mechanical polishing, wherein
the compound (a) has not less than 4 hydroxyl groups, and a weight average molecular weight measured by size exclusion chromatography (SEC) using polyethylene oxide as a standard sample for calibration of 100 - 50,000, and a hydroxyl group content of 5 - 40 mmol/g,
the compound (b) has not less than 4 amino groups, and a number average molecular weight measured by an ebullioscopic method of 300 - 100,000, and an amino group content of 3 - 30 mmol/g, and
wherein the mass ratio the compound (a)/compound (b)) is 0.10 - 500.

2. The use according to claim 1, wherein the mass ratio of compound (a)/compound (b) is 0.10 - 100.

3. The use according to claim 1 or 2, wherein the compound (a) has a skeleton derived from a monosaccharide.

4. The use according to any one of claims 1 - 3, wherein the compound (a) is at least one selected from the group consisting of a compound wherein 2 - 50 monosaccharides are bonded and a derivative thereof.

5. The use according to any one of claims 1 - 4, wherein the compound (b) is at least one selected from the group consisting of polyalkyleneimine (b1); polymer (b2) obtained by polymerizing 25 - 100 mass % of at least one monomer selected from the group consisting of allylamine, N-alkylallylamine, N,N-dialkylallylamine, diallylamine, N-alkyldiallylamine, vinylamine, vinylpyridine and N,N-dialkylaminoethyl (meth)acrylate, wherein the alkylene is an alkylene group having 1 - 6 carbon atoms, and the alkyl is an alkyl group having 1 - 4 carbon atoms, and 75 - 0 mass % of other monomer having an unsaturated double bond; and derivatives thereof.

6. The use to any one of claims 1-5, wherein the compound (b) has at least one secondary amino group and/or at least one tertiary amino group.

7. A slurry for chemical mechanical polishing, comprising compound (a), compound (b), abrasive grain (c) and water, wherein
the compound (a) has not less than 4 hydroxyl groups, and a weight average molecular weight measured by size exclusion chromatography (SEC) using polyethylene oxide as a standard sample for calibration of 100 - 50,000, and a hydroxyl group content of 5 - 40 mmol/g,
the compound (b) has not less than 4 amino groups, and a number average molecular weight measured by an ebullioscopic method of 300 - 100,000, and an amino group content of 3 - 30 mmol/g, and
wherein the mass ratio of compound (a)/compound (b) is 0.10 - 500.

8. The slurry for chemical mechanical polishing according to claim 7, wherein the abrasive grain (c) is silica.

9. The slurry for chemical mechanical polishing according to claim 7 or 8, wherein a concentration of the compound (a) is 0.01 - 10 mass %, a concentration of the compound (b) is 0.001 - 5 mass %, and a concentration of the abrasive grain (c) is 0.2 - 30 mass %.

10. The slurry for chemical mechanical polishing according to any one of claims 7 - 9, which has a pH of 9 - 13.

11. A chemical mechanical polishing method, wherein an insulating film is polished using the slurry for chemical mechanical polishing according to any one of claims 7 - 10.

12. The chemical mechanical polishing method according to claim 11, wherein a silicon oxide film on a silicon nitride film is polished.

## Patentansprüche

1. Verwendung eines Additivs, das Verbindung (a) und Verbindung (b) umfasst, als Erosionsinhibitor für chemisch-mechanisches Polieren, wobei
Verbindung (a) nicht weniger als 4 Hydroxygruppen aufweist und ein durch Ausschlusschromatographie (SEC) unter Verwendung von Poly-ethylenoxid als Standardprobe zur Eichung gemessenes Gewichtsmittel des Molekulargewichts von 100 bis 50 000 und einen Hydroxygruppengehalt von 5 bis 40 mmol/g aufweist;
Verbindung (b) nicht weniger als 4 Aminogruppen aufweist und ein durch ein ebullioskopisches Verfahren gemessenes Zahlenmittel des Molekular-gewichts von 300 bis 100 000 und einen Aminogruppengehalt von 3 bis 30 mmol/g aufweist; und
wobei das Massenverhältnis von Verbindung (a)/Verbindung (b) 0,10 bis 500 beträgt.

2. Verwendung gemäß Anspruch 1, wobei das Massenverhältnis von Verbindung (a)/Verbindung (b) 0,10 bis 100 beträgt.

3. Verwendung gemäß Anspruch 1 oder 2, wobei Verbindung (a) ein von einem Monosaccharid abgeleitetes Gerüst aufweist.

4. Verwendung gemäß einem der Ansprüche 1 bis 3, wobei Verbindung (a) wenigstens eine ist, die aus der Gruppe ausgewählt ist, die aus einer Verbindung, bei der 2 bis 50 Monosaccharide miteinander verbunden sind, und einem Derivat davon besteht.

5. Verwendung gemäß einem der Ansprüche 1 bis 4, wobei Verbindung (b) wenigstens eine ist, die aus der Gruppe ausgewählt ist, die aus Polyalkylenimin (b1), Polymer (b2), das durch Polymerisieren von 25 bis 100 Massen-% wenigstens eines Monomers, das aus der Gruppe ausgewählt ist, die aus Allylamin, N-Alkylallylamin, N,N-Dialkylallylamin, Diallylamin, N-Alkyldiallylamin, Vinylamin, Vinylpyridin und N,N-Dialkylaminoethyl(meth)acrylat besteht, erhalten wird, wobei das Alkylen eine Alkylengruppe mit 1 bis 6 Kohlenstoffatomen ist und das Alkyl eine Alkylgruppe mit 1 bis 4 Kohlenstoffatomen ist, und 75 bis 0 Massen-% andere Monomere mit einer ungesättigten Doppelbindung sowie Derivaten davon besteht.

6. Verwendung gemäß einem der Ansprüche 1 bis 5, wobei Verbindung (b) wenigstens eine sekundäre Aminogruppe und/oder wenigstens eine tertiäre Aminogruppe aufweist.

7. Aufschlämmung für chemisch-mechanisches Polieren, die Verbindung (a), Verbindung (b), Schleifkörner (c) und Wasser umfasst, wobei
Verbindung (a) nicht weniger als 4 Hydroxygruppen aufweist und ein durch Ausschlusschromatographie (SEC) unter Verwendung von Polyethylenoxid als Standardprobe zur Eichung gemessenes Gewichtsmittel des Molekulargewichts von 100 bis 50 000 und einen Hydroxygruppengehalt von 5 bis 40 mmol/g aufweist;
Verbindung (b) nicht weniger als 4 Aminogruppen aufweist und ein durch ein ebullioskopisches Verfahren gemessenes Zahlenmittel des Molekulargewichts von 300 bis 100 000 und einen Aminogruppengehalt von 3 bis 30 mmol/g aufweist; und
wobei das Massenverhältnis von Verbindung (a)/Verbindung (b) 0,10 bis 500 beträgt.

8. Aufschlämmung für chemisch-mechanisches Polieren gemäß Anspruch 7, wobei es sich bei dem Schleifkorn (c) um Siliciumoxid handelt.

9. Aufschlämmung für chemisch-mechanisches Polieren gemäß Anspruch 7 oder 8, wobei die Konzentration der Verbindung (a) 0,01 bis 10 Massen-% beträgt, die Konzentration der Verbindung (b) 0,001 bis 5 Massen-% beträgt und die Konzentration des Schleifkorns (c) 0,2 bis 30 Massen-% beträgt.

10. Aufschlämmung für chemisch-mechanisches Polieren gemäß einem der Ansprüche 7 bis 9, die einen pH-Wert von 9 bis 13 aufweist.

11. Chemisch-mechanisches Polierverfahren, wobei eine isolierende Folie unter Verwendung der Aufschlämmung für chemisch-mechanisches Polieren gemäß einem der Ansprüche 7 bis 10 poliert wird.

12. Chemisch-mechanisches Polierverfahren gemäß Anspruch 11, wobei ein Siliciumoxidfilm auf einem Siliciumnitridfilm poliert wird.

## Revendications

1. Utilisation d'un additif comprenant un composé (a) et un composé (b) à titre d'inhibiteur d'érosion pour polissage mécano-chimique, dans laquelle
le composé (a) ne contient pas moins de 4 groupes hydroxyle, et a un poids moléculaire moyen en poids, mesuré par chromatographie d'exclusion stérique (SEC) en utilisant l'oxyde de polyéthylène comme échantillon standard pour l'étalonnage, de 100 à 50 000, et une teneur en groupes hydroxyle de 5 à 40 mmol/g,
le composé (b) ne contient pas moins de 4 groupes amino, et a un poids moléculaire moyen en nombre, mesuré par une méthode ébullioscopique, de 300 à 100 000, et une teneur en groupes amino de 3 à 30 mmol/g, et
dans laquelle le rapport en poids composé (a)/composé (b) est de 0,10 à 500.

2. Utilisation selon la revendication 1, dans laquelle le rapport en poids composé (a)/composé (b) est de 0,10 à 100.

3. Utilisation selon la revendication 1 ou 2, dans laquelle le composé (a) a un squelette dérivé d'un monosaccharide.

4. Utilisation selon l'une quelconque des revendications 1 à 3, dans laquelle le composé (a) est au moins un composé choisi dans le groupe constitué par un composé dans lequel de 2 à 50 monosaccharides sont liés et un dérivé de celui-ci.

5. Utilisation selon l'une quelconque des revendications 1 à 4, dans laquelle le composé (b) est au moins un composé choisi dans le groupe constitué par un polyalkylèneimine (b1) ; un polymère (b2) obtenu par polymérisation de 25 à 100 % en poids d'au moins un monomère choisi dans le groupe constitué par une allylamine, N-alkylallylamine, N,N-dialkylallylamine, diallylamine, N-alkyldiallylamine, vinylamine, vinyl-pyridine et un (méth)acrylate de N,N-dialkylamino-éthyle, dans lesquels l'alkylène est un groupe alkylène ayant de 1 à 6 atomes de carbone, et l'alkyle est un groupe alkyle ayant de 1 à 4 atomes de carbone, et de 75 à 0 % en poids d'un autre monomère ayant une double liaison insaturée ; et leurs dérivés.

6. Utilisation selon l'une quelconque des revendications 1 à 5, dans laquelle le composé (b) contient au moins un groupe amino secondaire et/ou au moins un groupe amino tertiaire.

7. Suspension épaisse pour polissage mécano-chimique, comprenant le composé (a), le composé (b), un grain abrasif (c) et de l'eau, dans laquelle
le composé (a) ne contient pas moins de 4 groupes hydroxyle, et a un poids moléculaire moyen en poids, mesuré par chromatographie d'exclusion stérique (SEC) en utilisant l'oxyde de polyéthylène comme échantillon standard pour l'étalonnage, de 100 à 50 000, et une teneur en groupes hydroxyle de 5 à 40 mmol/g,
le composé (b) ne contient pas moins de 4 groupes amino, et a un poids moléculaire moyen en nombre, mesuré par une méthode ébullioscopique, de 300 à 100 000, et une teneur en groupes amino de 3 à 30 mmol/g, et
dans laquelle le rapport en poids composé (a)/composé (b) est de 0,10 à 500.

8. Suspension épaisse pour polissage mécano-chimique selon la revendication 7, dans laquelle le grain abrasif (c) est la silice.

9. Suspension épaisse pour polissage mécano-chimique selon la revendication 7 ou 8, dans laquelle une concentration du composé (a) est de 0,01 à 10 % en poids, une concentration du composé (b) est de 0,001 à 5 % en poids, et une concentration du grain abrasif (c) est de 0,2 à 30 % en poids.

10. Suspension épaisse pour polissage mécano-chimique selon l'une quelconque des revendications 7 à 9, qui a un pH de 9 à 13.

11. Procédé de polissage mécano-chimique, dans lequel un film isolant est poli à l'aide de la suspension épaisse pour polissage mécano-chimique selon l'une quelconque des revendications 7 à 10.

12. Procédé de polissage mécano-chimique selon la revendication 11, dans lequel un film en oxyde de silicium sur un film en nitrure de silicium est poli.
